Europäisches Patentamt

European Patent Office

Office européen des brevets

(11) Numéro de publication: **0 317 443**
A1

# DEMANDE DE BREVET EUROPEEN

(21) Numéro de dépôt: 88402907.5

(22) Date de dépôt: 18.11.88

(51) Int. Cl.⁴: **G 06 F 15/06**
G 11 C 11/00

(30) Priorité: 20.11.87 FR 8716062

(43) Date de publication de la demande:
24.05.89 Bulletin 89/21

(84) Etats contractants désignés: **DE ES GB IT NL**

(71) Demandeur: **SGS-THOMSON MICROELECTRONICS S.A.**
**7, Avenue Galliéni**
**F-94250 Gentilly (FR)**

(72) Inventeur: **Sourgen, Laurent**
**CABINET BALLOT-SCHMIT 84, Avenue Kléber**
**F-75116 Paris (FR)**

**Lisimaque, Gilles**
**CABINET BALLOT-SCHMIT 84, Avenue Kléber**
**F-75116 Paris (FR)**

(74) Mandataire: **Ballot, Paul Denis Jacques et al**
**Cabinet Ballot-Schmit 84, avenue Kléber**
**F-75116 Paris (FR)**

(54) Composant électronique monolithique.

(57) On réalise un composant électronique monolithique en économisant de la place sur le substrat semi-conducteur. La place gagnée (16) résulte de l'affectation d'un décodeur unique (9-10) à un plan mémoire mixte comprenant des cellules mémoires mortes (4) et des cellules mémoires programmables (5). Lorsque pour des raisons diverses il est nécessaire d'organiser une communication entre l'espace mémoire comportant les mémoires mortes et l'espace mémoire comprenant les mémoires programmables, on transfert (11) le contenu d'information, de tout ou partie, des mémoires mortes dans la mémoire de traitement du circuit électronique monolithique. On montre qu'on gagne ainsi de la place dans ce circuit en réduisant la taille des décodeurs d'accès.

EP 0 317 443 A1

Description

# COMPOSANT ELECTRONIQUE MONOLITHIQUE

La présente invention a pour objet un composant électronique monolithique comportant essentiellement sur un même substrat semi-conducteur un processeur de traitement, une mémoire dite de calcul, et un double plan mémoire contenant des cellules mémoires mortes, c'est-à-dire programmées, et des cellules mémoires vives, c'est-à-dire programmables. Le but de l'invention est de contribuer à l'augmentation de la densité d'intégration de fonctions électroniques sur un même substrat semi-conducteur, ainsi que de contribuer à l'accélération de l'exécution des opérations effectuées dans ce composant électronique monolithique.

Un composant électronique monolithique complet comporte d'une manière générale un processeur de traitement, une mémoire de calcul et deux ou même plusieurs plans mémoires. Un premier plan mémoire comporte des cellules mémoire mortes : elles sont chargées d'un contenu d'information représentatif d'instructions élémentaires à effectuer avec ce composant. Essentiellement ces instructions élémentaires peuvent concerner des opérations d'écriture pour écrire dans le plan mémoire contenant les cellules mémoires programmables. En effet, pour donner le plus d'universalité possible à un tel composant monolithique complet il faut que des instructions spécifiques, représentatives de la fonction à laquelle un utilisateur destine ce composant, ainsi qu'éventuellement quelques données, puissent être inscrites dans les cellules mémoires programmables de ce plan mémoire. Le composant monolithique ainsi conditionné par l'utilisateur est alors prêt à fonctionner en échangeant des informations avec le monde extérieur, au travers de sa mémoire de traitement, et selon un protocole défini par les instructions inscrites dans les mémoires programmables et exécutées par le processeur de traitement.

Le fonctionnement de ce système n'est possible qu'en utilisant des décodeurs d'accès aux cellules mémoires de chacune des trois mémoires, respectivement de la mémoire de traitement, de la mémoire des cellules mémoires programmables, et de la mémoire des cellules mémoires mortes. Or les décodeurs d'accès occupent de la place dans le substrat semi-conducteur : ils occupent d'autant plus de place qu'il y en a trois. On a tenté de réduire le nombre de ces décodeurs en concevant un système dans lequel un décodeur serait commun à deux de ces espaces mémoires ensemble. Cette solution de type théorique s'est cependant heurtée aux conditions d'utilisation du composant monolithique en question.

En effet, pour l'opération de programmation du plan mémoire des cellules mémoires programmables il est nécessaire d'avoir accès, en même temps, d'une part à l'espace mémoire comportant les cellules mémoires mortes (pour connaître la nature des instructions d'écriture pour écrire dans ce plan mémoire des mémoires programmables), et d'autre part il est nécessaire de pouvoir accéder à chacune de ces mémoires programmables elles-mêmes. En conséquence il est impossible d'utiliser un même décodeur pour accéder, en même temps, dans l'espace mémoire des mémoires mortes et dans l'espace mémoire des mémoires programmables. De même, pendant la phase de programmation il n'est pas envisageable de remplacer le décodeur des mémoires programmables et le décodeur des mémoires de traitement par un décodeur unique : ces deux espaces mémoires doivent aussi travailler en même temps.

Néanmoins dans l'invention on a résolu ce problème de l'encombrement des décodeurs en réalisant un décodeur commun à l'espace mémoire des mémoires mortes et à l'espace mémoire des mémoires programmables. On montrera plus loin que le fait de retenir un décodeur commun permet de gagner de la place : à capacité égale de la somme des deux espaces mémoires considérés, un décodeur commun occupe moins de place que les deux décodeurs propres à ces deux espaces. Pour résoudre alors le problème que pose l'utilisation d'un même décodeur simultanément pour accéder à deux espaces mémoires distincts, on a prévu qu'à un moment choisi par exemple au moment de la mise sous tension du composant électronique monolithique, le contenu d'information stocké dans les mémoires mortes est immédiatement transféré dans la mémoire de traitement du micro-processeur. Le moment choisi peut être cependant un autre moment. Par un ordre à cet effet, on peut provoquer ce transfert de contenu d'information. Dans le cas le plus courant où les instructions à tranférer ne concernent que des instructions d'écriture, l'ensemble de ces instructions d'écriture, stockées en mémoires mortes, est alors transféré dans la mémoire de traitement du micro-processeur.

Pour exécuter alors les opérations de programmation de l'espace des cellules mémoires programmables, le micro-processeur exécute les instructions qu'il lit maintenant dans sa mémoire de traitement (et auxquelles il accède par le décodeur de cette mémoire) et non plus, comme avant, dans sa mémoire morte. Lorsque ces opérations de programmation sont terminées, o à chaque nouvelle utilisation du circuit intégré monolithique si aucune programmation ne doit plus être faite dans la mémoire programmable, on peut envoyer depuis l'extérieur, ou plus sûrement sous le contrôle d'un logiciel interne, une instruction qui efface le contenu de la mémoire de traitement de telle manière que cette mémoire de traitement, via son propre décodeur, puisse servir maintenant d'interface pour le traitement des informations provenant de l'extérieur du composant électronique monolithique et qui sont destinées à y être traitées selon le programme qui vient d'être programmé dans l'espace des cellules mémoires programmables de ce composant.

L'invention a donc pour objet un composant électronique monolithique comportant :
- un processeur de traitement,

- une mémoire dite de traitement munie de cellules mémoires de traitement et munie d'un circuit de décodage de l'accès à ces cellules mémoires de traitement,
- et un plan mémoire muni de cellules mémoires mortes et de cellules mémoires programmables caractérisé en ce qu'il comporte :
- un circuit commun de décodage de l'accès à ces cellules mémoires programmables et à ces cellules mémoires mortes,
- et des moyens pour transférer une partie du contenu d'information des cellules mémoires mortes dans les cellules mémoires de traitement.

En variante ce tranfert peut être provoqué lors de la mise sous tension de l'alimentation du circuit intégré monolithique ou à la demande d'un logiciel programme enregistré dans la mémoire morte elle-même.

Dans un perfectionnement de l'invention le plan mémoire contenant les cellules mémoires mortes et les cellules mémoires programmables est un plan mémoire dont les cellules mémoires, quelles que soient leurs natures, sont réalisées en une même technologie. En particulier ces cellules mémoires sont réalisées avec des transistors à grille flottante, programmables électriquement pour l'espace mémoire comportant les cellules mémoires programmables, et programmables par masque pour l'espace mémoire comportant les mémoires mortes. La programmation par masque peut consister à implanter dans le canal de conduction des transistors à grille flottante des cellules mémoires mortes, des impuretés avec une concentration différente selon que ces cellules mémoires sont destinées à contenir une information représentant un état logique ou un autre. Cette manière de faire présente l'avantage que l'observation extérieure du plan mémoire, même au microscope, ne révèle ni le lieu ni le contenu des cellules mémoires programmées. Mais la programmation par masque peut être différente : classiquement il peut suffire de supprimer la zone drain-source des cellules mémoires mortes concernées . Au lieu de transistor à grille flottante dans les points mémoires on est alors en présence de dispositifs à grille flottante.

L'invention sera mieux comprise à la lecture de la description qui suit et à l'examen des figures qui l'accompagnent. Celles-ci ne sont données qu'à titre indicatif et nullement limitatif de l'invention. Les figures montrent :

   - figure 1 : la représentation schématique d'un circuit intégré monolithique selon l'invention ;
   - figures 2 et 3 : les particularités de programmation des cellules mémoires programmables et des cellules mémoires mortes respectivement selon l'état logique à y programmer ;
   - figure 4 : une représentation schématique d'un plan mémoire mixte contenant des cellules mémoires mortes et des cellules mémoires programmables, et muni d'un même décodeur.

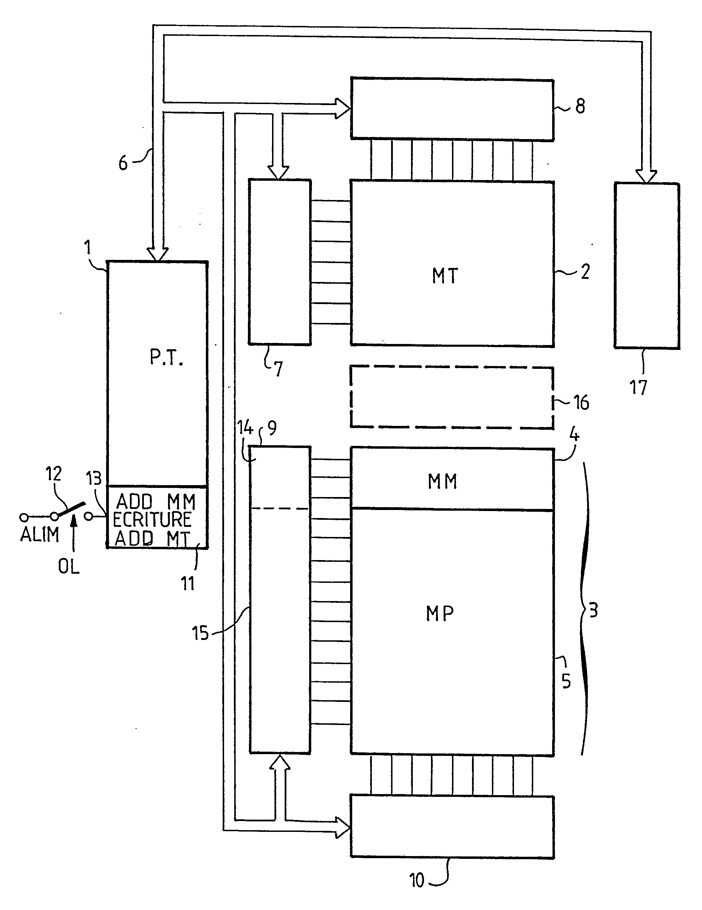

La figure 1 est une représentation schématique d'un circuit intégré électronique monolithique selon l'invention. Ce circuit intégré comporte un processeur de traitement 1 , une mémoire de traitement 2 et un plan mémoire 3. Le plan mémoire 3 est un plan mémoire mixte : il comporte un espace mémoire 4 muni de cellules mémoires mortes (que l'utilisateur ne peut en théorie pas programmer). Il comporte également un espace mémoire 5 muni de cellules mémoires programmables. La mémoire de traitement 2 est en relation avec le processeur de traitement 1 par l'intermédiaire d'un bus 6 et d'un décodeur 7-8, respectivement de lignes de bits et de lignes de mots. Le plan mémoire 3 est aussi en relation avec le processeur de traitement par l'intermédiaire du même bus 6 et d'un décodeur unique pour les deux espaces mémoires 4 et 5. Le décodeur unique comprend un décodeur 9 de lignes de bits et un décodeur 10 de lignes de mots. Comme autre caractéristique le circuit monolithique de l'invention comporte également une instruction préprogrammée 11 simple. Cette instruction préprogrammée est de préférence, préprogrammée dans le processeur de traitement lui-même.

L'instruction préprogrammée 11 à pour objet d'aller chercher à certaines adresses du plan 4 des mémoires mortes des instructions, par exemple d'écriture ou de programmation des cellules mémoires du plan mémoire programmable 5, et de les écrire à des adresses correspondantes de la mémoire de traitement 2. Cette instruction 11 est destinée, dans l'exemple représenté, à être exécutée à chaque fois que le circuit intégré monolithique est mis sous tension. Cependant, dans les cas où l'utilisation de cette instruction ne se justifierait plus (par exemple si l'utilisateur du circuit intégré monolithique désire qu'on ne puisse plus programmer l'espace mémoire 5 une fois qu'il a été programmé une première fois) il peut être décidé de rendre inopérante l'exécution de cette instruction. Ceci peut être obtenu, symboliquement, par l'ouverture d'un interrupteur 12 commandé par un ordre logique OL et interposé en série entre l'alimentation et une entrée 13 de validation de l'exécution l'instruction préprogrammée 11. Le plan mémoire 5 peut cependant comporter deux espaces différents, un premier espace destiné à ne plus être programmé et un deuxième espace destiné à être programmé à la demande.

La figure 1 montre clairement le gain de place qui résulte de cette solution. Si à capacité égale de l'espace mémoire 4 des mémoires mortes et de l'espace mémoire 5 des mémoires programmables le décodeur 9 de lignes de bits commun aux deux espaces n'est pas différent, dans son encombrement, de la somme des encombrements des décodeurs 14 et 15 de lignes de bits de chacun de ces espaces mémoires, comme dans l'état de la technique citée, il est par contre tout à fait visible qu le décodeur de lignes de mots 10 est maintenant commun à l'espace 4 et à l'espace 5. En conséquence un décodeur spécifique de lignes de mots 16, montré en tirets, n'est plus nécessaire pour accéder aux cellules mémoires de l'espace 4.

Le fonctionnement du circuit monolithique de l'invention, dans un exemple, est le suivant. A la mise sous tension l'exécution de l'instruction 11 provoque le transfert des instructions de programmation contenues dans l'espace 4, dans l'espace mémoire 2. Au moyen d'un circuit d'entrée-sortie 17 également en relation avec le bus 6, il est possible de faire exécuter par le processeur 1 les instructions de programmation contenues maintenant dans la mémoire de traitement 2 pour programmer, selon une utilisation désirée, l'espace 5 des mémoires programmables. Lorsque cette opération de programmation est terminée, on peut éventuellement envoyer l'ordre logique OL au moyen du circuit d'entrée-sortie 17 afin d'ouvrir l'interrupteur 12 et de condamner la programmation ultérieure de la mémoire programmable 5. Lors de l'utilisation du circuit intégré électronique contenant maintenant les fonctions préprogrammées, ces fonctions sont normalement accessibles par le décodeur 9-10 tandis que la mémoire de traitement 12 est elle normalement accessible par son décodeur d'accès 7-8.

Un transistor à grille flottante vierge, c'est-à-dire non programmé, possède une tension de seuil de conduction par exemple de l'ordre de 1 volt, et délivre un courant important IM lorsqu'on soumet son drain et sa source à une différence de potentiel égale à un potentiel de lecture VL, de l'ordre de 2,5 volts par exemple. Lorsque ce transistor a été programmé, c'est-à-dire lorsque des électrons ont été injectés dans sa grille flottante en quantité $\Delta Q_1$, le seuil de conduction de ce transistor se décale et il ne devient plus conducteur, par exemple, que si on lui applique une tension entre drain et source de l'ordre de 4 volts. Comme cette tension est supérieure à la tension de lecture VL, ce transistor n'est pas susceptible de laisser passer un courant fort. il ne laisse passer qu'un courant faible lo.

Les courbes caractéristiques de la conduction des transistors à grille flottante se déplacent lorsque les canaux de conduction de ces transistors ont été dopés, qu'ils soient dans un état de programmation ou dans un autre. Le seuil du transistor vierge est légèrement décalé, il est passé par exemple à 1,5 volts, et le courant que ce transistor est susceptible de laisser passer lorsqu'il est soumis à une même tension de lecture VL que précédemment est maintenant réduit, par exemple il ne vaut plus que Im bien inférieur à IM. Par contre quand ce transistor a été programmé, l'injection de charges a été plus efficace : le nombre d'électrons $\Delta Q_2$ injectés dans sa grille flottante est maintenant supérieur au nombre de ceux qui avaient pu être injectés quand le canal de conduction n'avait pas été dopé. Il en résulte que le seuil de conduction d'un transistor à grille flottante dopé, et programmé, est maintenant décalé d'une manière beaucoup plus importante : par exemple il vaut 6 volts. Ceci a pour effet que le pouvoir de rétention de l'information dans ce transistor à grille flottante en est augmenté. Autrement dit le temps de fuite et le caractère non volatile du stockage de l'information dans un tel transistor à grille flottante est augmenté.

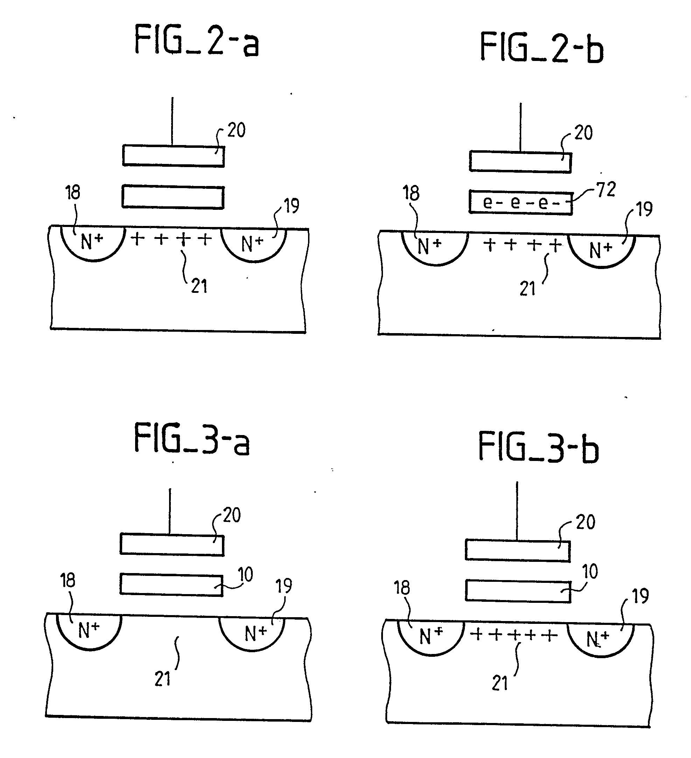

Les figures 2 et 3 montrent l'exploitation de ce dopage en vue de constituer le mode de programmation des cellules mémoires vives et des cellules mémoires mortes du plan mémoire mixte selon l'invention. Le mode de programmation des cellules mémoires mortes est effectué par masquage du plan mémoire au moment de la fabrication du circuit intégré électronique désiré. Il y est fait par exemple une distinction entre les cellules mémoires mortes vierges (non programmées) dont le canal de conduction du transistor à grille flottante a la courbe caractéristique de conduction d'un transistor à grille flottante non dopé et non programmé, et des cellules mémoires mortes dites programmées (sans qu'il soit injecté de charges dans la grille flottante) dont la courbe caractéristique de conduction du canal de conduction est celle d'un transistor à grille flottante dopé, mais non programmé, ou même mieux, une courbe décalée en exagérant le dopage. Le décalage des courbes caractéristiques de conduction selon qu'elles correspondent à des cellules programmées ou non ne correspond pas alors à une injection de charges électroniques $\Delta Q$ dans la grille flottante mais à une variation $\Delta I$ de l'implantation des impuretés dans ce canal de conduction.

La mesure de la différence entre les courants débités par les cellules mémoires peut permettre de différencier l'état de programmation des cellules. Si l'implantation des impuretés est exagérée, le courant débité par une cellule mémoire morte "programmée" devient proche de lo par exemple. Dans ce cas la mesure de l'état de programmation des cellules mémoires vives et des cellules mémoires mortes peut être effectuée avec un même senseur de courant dont le seuil de déclenchement se situe par exemple à 2.lo ou à Im/2.

Les figures 2 et 3 montrent en coupe des représentations schématiques respectivement de transistors à grille flottante utilisables dans les cellules mémoires programmables, et de transistors à grille flottante utilisables dans les cellules mémoires mortes. Ces figures montrent des transistors munis de régions drain et source respectivement 18 et 19 et d'une grille de commande 20. Ces transistors sont des transistors à canal N et ils sont conducteurs quand un potentiel positif est appliqué sur sa grille 20. Une implantation d'impuretés de type P en surface du canal 21 de conduction des transistors des figures 2a, 2b et 3b est représentée. Ceci a pour effet de déplacer le seuil de conduction de ces transistors vers les valeurs élevées. En pratique avec une implantation d'atomes de Bore en concentration de $10^{17}$ atomes par $cm^3$, ce seuil de conduction vaut de l'ordre de deux volts.

Les figures 2a et 2b montrent des transistors à grille flottante dont le canal de conduction 9 a été dopé de manière à favoriser l'opération de programmation. La figure 2b montre schématiquement, par la présence d'électrons $e^-$ prisonniers dans la grille flottante 72 de ce transistor, sur quoi repose le principe de la programmation. Par contre aux figures 3a et 3b on montre des transistors à grille flottante utilisables dans des cellules mémoires mortes et dont le caractère non programmé, figure 3a, et programmé, figure 3b, est matérialisé par la présence ou non d'une implantation d'impuretés dans le canal de conduction 21. Les comparaisons des figures 2 et 3 montrent que dans un plan mémoire mixte, comportant des cellules mémoires mortes et des cellules mémoires vives, la technologie de fabrication des transistors constituant les organes de mémorisation de ces cellules mémoires est la même : dans tout les cas il s'agit de transistors comportant des grilles flottantes.

Dans le cas où la comparaison des courant passant dans les transistors des cellules mémoires mortes amène à comparer un courant IM à un courant Im le plan mémoire ne comporte que deux types de transistors à grille flottante. Un premier type est constitué par les transistors dont le canal de conduction a été dopé par des implantations d'impuretés (figures 2a, 2b et 3b), l'autre type est constitué par des transistors à grille flottante dont le canal de conduction ne possède aucune impureté de dopage (figure 3a). On remarque dans ce cas une quasi impossibilité de définir par une observation extérieure au microscope si les cellules mémoires observées sont du type cellules mémoires mortes ou du type cellules mémoires programmables.

Dans le cas où on a exagéré l'implantation des impuretés dans le canal de conduction des cellules mémoires mortes programmées on peut de même se contenter de deux types de cellules mémoires : les cellules mémoires mortes non programmées comportant alors, elles aussi, le même type de concentration d'impuretés que les cellules mémoires programmables vierges; les cellules mémoires mortes programmées comportant dans le canal de conduction de leur transistor à grille flottante une plus grande concentration d'impuretés. On remarque d'ailleurs que dans ce dernier cas la distinction entre les cellules programmées et les cellules non programmées peut se faire de la même manière selon qu'elles sont programmables ou mortes. Quand elles sont non programmées leur courant de conduction vaut Im, quand elles sont programmées leur courant de conduction vaut Io.

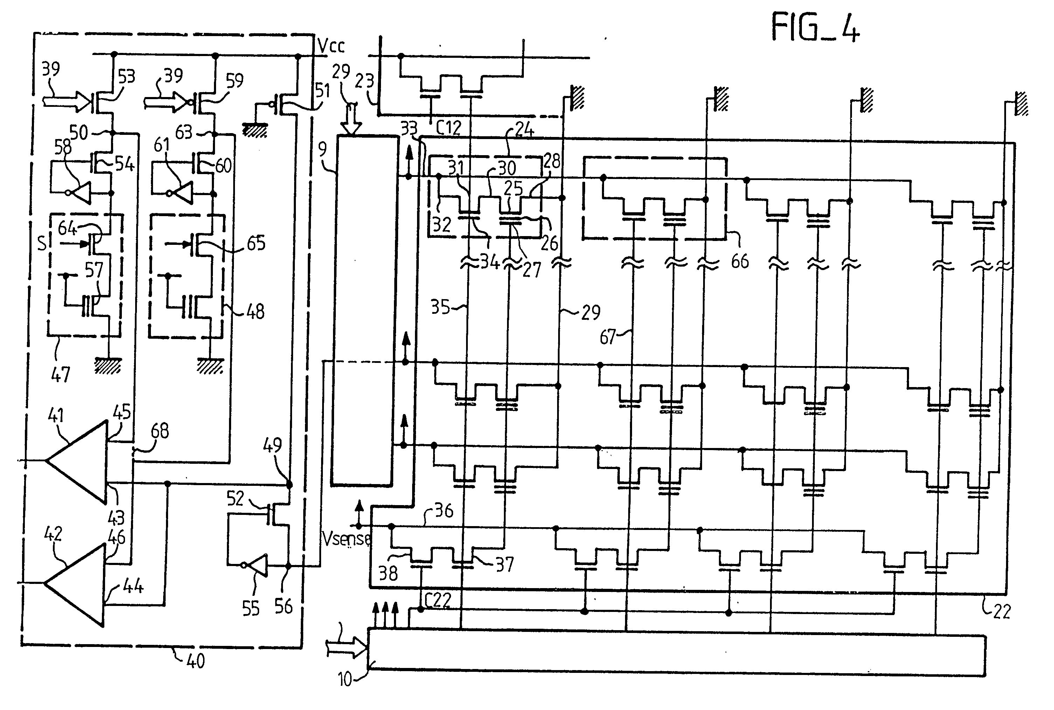

La figure 4 représente un plan mémoire muni de cellules mémoires selon l'invention. Ce plan mémoire comporte par exemple des blocs mémoires tels que 22 ou 23 comportant, chacun, un même nombre de cellules mémoires auxquelles on peut accéder par un décodeur de lignes de mots 10 et par un décodeur de lignes de bits 9. Chaque cellule mémoire, par exemple la cellule mémoire 24, comporte un transistor à grille flottante 25, muni d'une grille flottante 26 et d'une grille de commande 27, relié par sa source 28 à une connexion de masse de réseau 29, et par son drain 30 à un transistor de commande 31. Le transistor de commande 31 est relié par son drain 32 à une ligne de bits 33 et par sa grille de commande 34 à une ligne de mots 35. Les lignes de bits 33 et les lignes de mots 35 proviennent respectivement du décodeur de lignes de bits 9 et du décodeur de lignes de mots 10.

Pour chaque bloc mémoire une connexion de conditionnement 36 achemine un potentiel de sensibilisation Vsense sur les grilles de commande 27 des transistors 25 à grille flottante des cellules mémoires. Cet acheminement est organisé par la mise en série de deux transistors respectivement d'accès 37 et de contrôle d'accès 38 en série l'un avec l'autre entre la connexion 36 et les grilles de commande 27. Ces transistors reçoivent respectivement sur leur grille de commande le signal disponible sur la ligne de mots 35 et un signal C de commande de bloc. Par exemple le transistor 38 reçoit le signal C22 relatif au bloc 22.

Lorsqu'une adresse 39 est appliquée sur les décodeurs 9 et 10, une cellule mémoire, par exemple la cellule mémoire 24, peut être lue. Un circuit de lecture 40 applique alors sur la ligne de bits 33 concernée par la cellule 24 un potentiel de lecture VL. Si la cellule mémoire 24 est programmée du courant passe avec une intensité sensible sur la ligne de bits 33, si elle n'est pas programmée le courant de fuite qui traverse la cellule 24 est faible. Le circuit de lecture 40 comporte des comparateurs pour extraire l'information d'état de programmation à partir de ce courant débité. Il comporte par exemple les deux comparateurs 41 et 42. Chacun de ces comparateurs 41 et 42 (qui dans la pratique sont des comparateurs de tension) reçoit sur une entrée respectivement 43 et 44 un signal correspondant au courant qui passe dans la cellule 24. Aux accès sur leurs autres entrées respectivement 45 et 46 les comparateurs 41 et 42 reçoivent un signal de référence relatif au fait que la cellule mémoire 24 serait une cellule mémoire vive ou une cellule mémoire morte.

Les potentiels représentatifs du courant qui passe dans la cellule 24 et les potentiels de référence relatifs aux courants qui passent dans des cellules mémoires étalons 47 ou 48 sont élaborés de la même façon. Par exemple ces potentiels proviennent à chaque fois du point milieu respectivement 49 ou 50 d'un pont diviseur à transistors, comportant les transistors respectivement 51-52 et 53-54. Ces ponts diviseurs de transistors sont en série d'une part, par l'intermédiaire du décodeur 9 de lignes de bits, avec la cellule mémoire 24 à lire, et d'autre part avec la cellule mémoire étalon 47. Aux pertes de tension par commutation dans le décodeur 9 près, on remarque que la succession des transistors 51-52 et de la cellule mémoire 24 est du même type que la succession des transistors 53-54 et de la cellule mémoire étalon 47.

Le fonctionnement de chacune de ces cascades est le suivant. Par exemple le transistor 51 est un transistor à canal P dont la grille est reliée à la masse : il est toujours conducteur. Il se comporte en définitive comme une résistance. Le transistor 52 est un transistor à canal N, sa grille est commandée par un rebouclage de sa source au moyen d'un inverseur 55. Ce rebouclage agit comme un régulateur. On peut montrer que la tension de lecture VL disponible sur la source 56 du transistor 52 baisse un peu, mais faiblement, lorsque la cellule mémoire 24 choisie est programmée : lorsque son transistor 25 est passant. Cette légère baisse de tension est néanmoins prise en compte par l'inverseur 55 pour être appliquée en contre-réaction sur la grille de commande du transistor 52. Ce dernier devient alors plus conducteur et injecte un courant plus important dans la cellule mémoire 24. La résistance interne de conduction de cette cellule mémoire fait alors remonter le potentiel disponible au point 56 de telle manière qu'on puisse considérer qu'il est sensiblement constant.

Dans ces conditions le potentiel disponible au point 49 résulte de la mise en série de la résistance de conduction du transistor 51 avec le transistor 52 entre deux potentiels sensiblement constants, Vcc d'une part et VL d'autre part. Compte tenu de la constance de la résistance de conduction du transistor 51 (il est toujours conducteur) on obtient au point 49 un potentiel représentatif du courant qui passe dans la cellule 24. Si la cellule 24 est programmée, si le transistor 25 est passant, le potentiel en 49 est faible. Dans le cas contraire le potentiel en 49 vaut sensiblement Vcc (moins la chute de tension dans le transistor 51).

Le potentiel de référence admis sur l'entrée 45 du comparateur de tension 41 est élaboré dans les mêmes conditions. La cellule étalon 47 peut être une cellule programmée : son transistor à grille flottante 57 est passant. Un inverseur 58 permet également d'obtenir une régulation de la tension de lecture appliquée à cette cellule étalon 47. En conséquence le potentiel disponible au point milieu 50 du pont diviseur à transistor 53-54 est obtenu dans les mêmes conditions. De manière à pouvoir faire une comparaison utile on choisit un transistor 53 deux fois moins résistant (deux fois plus gros) que le transistor 51. Pour un même courant débité dans les cellules à lire 24 et étalon 47, quand elles sont toutes deux programmées, le potentiel étalon disponible à l'entrée 45 du comparateur 41 est supérieur au potentiel du point 49 disponible à l'entrée 43 de ce comparateur 41. Par contre si la cellule 24 n'est pas programmée (ce qu'en définitive on cherche à savoir) le potentiel au point 49 est presque égal à Vcc. Il est donc supérieur au potentiel étalon disponible au point 50 qui lui ne change pas.

Dans le cas où la cellule 24 est une cellule mémoire programmable on peut considérer que le signal disponible à l'entrée 43 du comparateur 41 est proportionnel à Im ou à Io selon que cette cellule est programmée ou non, tandis que le signal disponible à l'entrée 45 du comparateur 41 doit être proportionnel à Im/2.

On a vu que si la cellule mémoire 24 est une cellule mémoire morte le courant qu'elle est susceptible de débiter peut être IM ou Im selon qu'elle n'est pas ou qu'elle est respectivement programmée. Il importe donc de comparer le courant débité par cette cellule 24 à IM/2. Cette nouvelle grandeur de référence est fournie par une autre cascade, du même type que les précédentes, comportant un autre pont diviseur de tension à transistors 59-60 en contre-réaction par un inverseur 61 et débitant dans une autre cellule étalon 48. Un autre comparateur 42 reçoit alors sur son entrée 44 un signal correspondant au courant qui passe dans la cellule mémoire à lire 24, et sur son entrée de référence 46 un signal délivré par le point milieu 63 du pont diviseur à transistors 59-60. Le choix de la tension de référence est tout à fait lié aux concentrations d'impuretés implantées dans les canaux de conduction des cellules mémoires mortes. La cellules mémoire étalon est bien entendu une cellule mémoire morte (programmée ou non selon le mode de comparaison choisi).

De manière à ne pas faire débiter inutilement les cellules mémoires étalons 47 et 48 il peut être prévu de mettre entre elles et leur pont diviseur à transistors respectif des transistors de commande respectivement 64 et 65 commandés par un signal commun S de validation de la lecture.

Il peut être utile de répartir les cellules mémoires mortes parmi les cellules mémoires programmables. Il en résulte qu'une cellule mémoire 24 peut par exemple être une cellule mémoire morte tandis qu'une cellule voisine 66, sur la même ligne de bits, est une cellule mémoire vive. Ou bien pour simplifier, sur certaines lignes de bits, par exemple la ligne de bits 33, des cellules mémoires sont des cellules mémoires programmables ou des cellules mémoires mortes selon qu'elles appartiennent à des lignes de mots de rang pair, ligne de mot 35, ou de rang impair ligne de mot 67. On peut alors utiliser le bit de parité de l'adresse-mot de la cellule mémoire à lire pour mettre en conduction, au choix, un des deux transistors 53 ou 59 des deux ponts diviseurs à transistors en cascade avec les cellules mémoires étalons respectivement 47 et 48. La cellule mémoire étalon dont le transistor est ainsi activé applique alors son potentiel de référence au comparateur correspondant. Ce comparateur peut délivrer l'information lue.

Pour cette raison l'adresse 39 (dans un cas simple le dernier bit de l'adresse-mot), est appliquée sur la grille de commande de ces transistors 53 et 59. De manière à les différencier, un de ces transistors sera un transistor à canal P tandis que l'autre sera un transistor à canal N. Par exemple pour une adresse impaire la cellule 24 programmable est lue. Le bit de parité vaut 1, et le transistor à canal N 53 est conducteur tandis que le transistor à canal P 59 est bloqué. Le cas inverse se produit pour la lecture de la cellule 66. Dans ces conditions les deux comparateurs 41 et 42 reçoivent sur leur entrée 43 et 44 respectivement, un même signal correspondant à l'information à lire, et un seul de ces comparateurs, selon la nature de la cellule mémoire à lire, délivre l'information lue. Ces deux comparateurs peuvent être remplacés par un comparateur unique. Par exemple le comparateur 41 peut recevoir sur son entrée 45 de référence, par une connexion 68, aussi bien le potentiel de référence élaboré par la cellule étalon 47 que celui élaboré par la cellule étalon 48. Seule celle de ces deux cellules qui est validée permet la comparaison. Le point milieu du pont diviseur à transistor de la cellule non validée reste en effet en l'air du fait du blocage de son transistor (53 ou 59).

La nature de l'instruction programmée 11 est la suivant (figure 1). Elle comporte essentiellement les adresses ADDMM en mémoire morte des instructions (ECRITURE) à transférer et les adresses ADDMT en mémoire de traitement où ces instructions doivent être rangées.

## Revendications

1. Composant électronique monolithique comportant :
- un processeur (1) de traitement,

- une mémoire (2) dite de traitement munie de cellules mémoires de traitement et munie d'un circuit (7-8) de décodage de l'accès (6) à ces cellules mémoires de traitement,

- et un plan (3) mémoire mixte muni de cellules mémoires mortes (4) et de cellules mémoires programmables (5),

caractérisé en ce qu'il comporte :

- un circuit (9-10) commun de décodage de l'accès à ces cellules mémoires mortes ou programmables,

- et des moyens (11) pour transférer une partie du contenu d'information des cellules mémoires mortes dans les cellules mémoires de calcul.

2. Composant selon la revendication 1 caractérisé en ce que les moyens de transfert comportent des moyens de transférer des instructions utiles à la programmation (11, ECRITURE) des cellules mémoires programmables.

3. Composant selon la revendication 1 ou la revendication 2 caractérisé en ce que les cellules mémoires mortes et les cellules mémoires programmables sont réalisées en une même technologie (figures 2 et 3) comportant des dispositifs à grille flottante.

4. Composant selon la revendication 3 caractérisé en ce que les mémoires mortes comportent des transistors à grille flottante dont le canal de conduction est dopé (figures 3a, 3b) différemment selon l'état de programmation qu'on veut leur imposer.

5. Composant selon l'une quelconque des revendications 1 à 4 caractérisé en ce qu ' il comporte des moyens (12-13) pour transférer la partie du contenu d'information lors de la mise sous tension de l'alimentation du circuit intégré monolithique.

## FIG_2-a

20

18

19

N+  + + + +  N+

21

## FIG_2-b

20

e- e- e-  72

18  19

N+  + + + +  N+

21

## FIG_3-a

20

10

18  19

N+  N+

21

## FIG_3-b

20

10

18  19

N+  + + + + +  N+

21

FIG_4

EP 0 317 443 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | EP-A-0 239 283  (HITACHI LTD) <br> * Figure 2; colonne 1, lignes 17-23; colonne 1, lignes 26-33; colonne 10, lignes 6-14; revendications 1-3 * <br> --- | 1-3 | G 06 F   15/06 <br> G 11 C   11/00 |
| Y | EP-A-0 224 206  (MITSUBISHI DENKI K.K.) <br> * Figures 1-5; page 7, ligne 5 - page 16, ligne 15 * <br> --- | 1,2 | |
| Y | PATENT ABSTRACTS Of JAPAN, vol. 6, no. 51 (P-108)[929], 6 avril 1982, page 150 P 108; & JP-A-56 165 984 (NIPPON DENKI K.K.) 19-12-1981 <br> * Résumé * <br> --- | 3 | |
| A | IBM TECHNICAL DISCLOSURE BULLETIN, vol. 14, no. 12, mai 1972, page 3721, New York, US; L.M. TERMAN: "Floating avalanche-injection metal-oxide semiconductor device with low-write voltage" <br> * En entier * <br> --- | 4 | |
| A | EP-A-0 227 965  (SGS MICROELETTRONICA) <br> * Revendications 1,2 * <br> --- | 4 | G 11 C <br> G 06 F <br> H 01 L |
| A | PATENT ABSTRACTS OF JAPAN, vol. 3, no. 143 (E-154), 27 novembre 1979; & JP-A-54 121 628 (TOKYO SHIBAURA DENKI K.K.) 20-09-1979 <br> ----- | 5 | |

DOMAINES TECHNIQUES RECHERCHES (Int. Cl.4)

Le présent rapport a été établi pour toutes les revendications

| Lieu de la recherche | Date d'achèvement de la recherche | Examinateur |
|---|---|---|
| LA HAYE | 10-01-1989 | DE LA FUENTE DEL AGUA Y. |